(19) Europäisches Patentamt
European Patent Office
Office européen des brevets

(11) **EP 4 618 456 A2**

## (12) EUROPEAN PATENT APPLICATION

(43) Date of publication:
**17.09.2025 Bulletin 2025/38**

(21) Application number: **25152397.3**

(22) Date of filing: **17.01.2025**

(51) International Patent Classification (IPC):
**H04L 1/00** (2006.01)

(52) Cooperative Patent Classification (CPC):
**H04L 1/0045**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.01.2024 FI 20245072**

(71) Applicant: **Nokia Solutions and Networks Oy 02610 Espoo (FI)**

(72) Inventors:
• **MOHAMMADI, Jafar**
  **Munich (DE)**
• **SPRINTSON, Alexander**
  **Basking Ridge, NJ (US)**

(74) Representative: **Nokia EPO representatives Nokia Technologies Oy Karakaari 7 02610 Espoo (FI)**

## (54) METHOD, APPARATUS AND COMPUTER PROGRAM

(57) There is provided a method, computer program, and first apparatus for causing the first apparatus to perform: causing a modified codeword to be formed by combining a noisy codeword received over a channel with a proxy codeword; and causing the modified codeword to be provided to a decoder for decoding.

Fig. 7

EP 4 618 456 A2

## Description

FIELD

The present application relates to apparatus for causing a modified codeword to be provided to a decoder for decoding.

BACKGROUND

A communication system can be seen as a facility that enables communication sessions between two or more entities such as user terminals, base stations and/or other nodes by providing carriers between the various entities involved in the communications session. A communication system can be provided for example by means of a communication network and one or more compatible communication devices. The communication sessions may comprise, for example, communication of data for carrying communications such as voice, video, electronic mail (email), text message, multimedia and/or content data and so on. Non-limiting examples of services provided comprise two-way or multi-way calls, data communication or multimedia services and access to a data network system, such as the Internet.

The communication system and associated devices typically operate in accordance with a given standard or specification which sets out what the various entities associated with the system are permitted to do and how that should be achieved. Communication protocols and/or parameters which shall be used for the connection are also typically defined. One example of a communications system is UTRAN (Universal Mobile Telecommunications System terrestrial radio access network (e.g., 3G radio)). Other examples of communication systems are the long-term evolution (LTE) of the Universal Mobile Telecommunications System (UMTS) radio-access technology and so-called 5G or New Radio (NR) networks. NR is being standardized by the 3rd Generation Partnership Project (3GPP).

SUMMARY

According to a first aspect, there is provided a first apparatus comprising means for performing: causing a modified codeword to be formed by combining a noisy codeword received over a channel with a proxy codeword; and causing the modified codeword to be provided to a decoder for decoding.

According to a second aspect, there is provided a first apparatus comprising: at least one processor; and at least one memory comprising code that, when executed by the at least one processor, causes the first apparatus to perform: causing a modified codeword to be formed by combining a noisy codeword received over a channel with a proxy codeword; and causing the modified codeword to be provided to a decoder for decoding.

According to a third aspect, there is provided a method for a first apparatus, the method comprising: causing a modified codeword to be formed by combining a noisy codeword received over a channel with a proxy codeword; and causing the modified codeword to be provided to a decoder for decoding.

According to a fourth aspect, there is provided a first apparatus comprising: causing circuitry for causing a modified codeword to be formed by combining a noisy codeword received over a channel with a proxy codeword; and causing circuitry for causing the modified codeword to be provided to a decoder for decoding.

The following may be performed by any (e.g., all) of the first to fourth aspects.

The first apparatus may be caused to perform generating the proxy codeword by randomly selecting the proxy codeword based on a valid set of codewords.

The generating the proxy codeword may comprise selecting a code, and generating the codeword based on the code.

The proxy codeword may correspond to a proxy message, and the apparatus may be caused to perform providing the proxy message and/or the proxy codeword to another apparatus.

The first apparatus may be caused to perform determining that the decoder is untrusted by the apparatus, wherein the causing the modified codeword to be provided to the decoder may comprise causing the modified codeword to be provided to the decoder based on the determination that the decoder is untrusted by the apparatus.

The first apparatus may be caused to perform: receiving, from the decoder, a decoded message that comprises an original message and a proxy message; removing the proxy message from the decoded message to recover the original message; and causing the original message to be provided to a second apparatus for processing.

According to a fifth aspect, there is provided a second apparatus comprising means for performing: receiving, from a decoder, a decoded message that comprises an original message and a proxy message; removing the proxy message from the decoded message to recover the original message; and processing the original message.

According to a sixth aspect, there is provided a second apparatus comprising at least one processor; and at least one memory comprising code that, when executed by the at least one processor, causes the second apparatus to perform: receiving, from a decoder, a decoded message that comprises an original message and a proxy message; removing the proxy message from the decoded message to recover the original message; and processing the original message.

According to a seventh aspect, there is provided a method for a second apparatus, the method comprising: receiving, from a decoder, a decoded message that comprises an original message and a proxy message; removing the proxy message from the decoded message to recover the original message; and processing the original message.

According to an eighth aspect, there is provided a second apparatus comprising: receiving circuitry for receiving, from a decoder, a decoded message that comprises an original message and a proxy message; removing circuitry for removing the proxy message from the decoded message to recover the original message; and processing circuitry for processing the original message.

The following may be performed by any (e.g., all) of the above fifth to eighth aspects.

The second apparatus may be caused to perform receiving the proxy message from a first apparatus.

The second apparatus may be caused to perform receiving the proxy message from the first apparatus with a corresponding proxy codeword.

The second apparatus may be caused to perform generating a proxy codeword corresponding to the proxy message by randomly selecting the proxy codeword from a valid set of codewords.

The generating the proxy codeword may comprise selecting a code, and generating the proxy codeword based on the code.

According to a ninth aspect, there is provided a decoder apparatus comprising means for performing: receiving, from another apparatus, a modified codeword that comprises a noisy codeword and a proxy codeword; determining, based on the modified codeword, a decoded message that comprises an original message and a proxy message; and providing the decoded message to another entity.

According to a tenth aspect, there is provided a decoder apparatus comprising: at least one processor; and at least one memory comprising code that, when executed by the at least one processor, causes the decoder apparatus to perform: receiving, from another apparatus, a modified codeword that comprises a noisy codeword and a proxy codeword; determining, based on the modified codeword, a decoded message that comprises an original message and a proxy message; and providing the decoded message to another entity.

According to an eleventh aspect, there is provided a method for a decoder apparatus, the method comprising: receiving, from another apparatus, a modified codeword that comprises a noisy codeword and a proxy codeword; determining, based on the modified codeword, a decoded message that comprises an original message and a proxy message; and providing the decoded message to another entity.

According to a twelfth aspect, there is provided a decoder apparatus comprising: receiving circuitry for receiving, from another apparatus, a modified codeword that comprises a noisy codeword and a proxy codeword; determining circuitry for determining, based on the modified codeword, a decoded message that comprises an original message and a proxy message; and providing circuitry for providing the decoded message to another entity.

In any (e.g., all) of the ninth the twelfth aspects, the another entity may comprise the another apparatus.

According to a thirteenth aspect, there is provided a third apparatus comprising means for performing: randomly selecting at least one of a proxy message or a proxy codeword; determining a proxy message-proxy codeword pair using the selected at least one of the proxy message or proxy codeword; and providing at least one of the proxy message or proxy codeword of said pair to another apparatus.

According to a fourteenth aspect, there is provided a third apparatus comprising: at least one processor; and at least one memory comprising code that, when executed by the at least one processor, causes the third apparatus to perform: randomly selecting at least one of a proxy message or a proxy codeword; determining a proxy message-proxy codeword pair using the selected at least one of the proxy message or proxy codeword; and providing at least one of the proxy message or proxy codeword of said pair to another apparatus.

According to a fifteenth aspect, there is provided a method for a third apparatus, the method comprising: randomly selecting at least one of a proxy message or a proxy codeword; determining a proxy message-proxy codeword pair using the selected at least one of the proxy message or proxy codeword; and providing at least one of the proxy message or proxy codeword of said pair to another apparatus.

According to a sixteenth aspect, there is provided a third apparatus comprising: selecting circuitry for randomly selecting at least one of a proxy message or a proxy codeword; determining circuitry for determining a proxy message-proxy codeword pair using the selected at least one of the proxy message or proxy codeword; and providing circuitry for providing at least one of the proxy message or proxy codeword of said pair to another apparatus.

The following may be performed by any (e.g., all) of the above thirteenth to sixteenth aspects.

The randomly selecting may comprise: randomly generating a number; and using the randomly generated number to perform said selecting.

The determining the proxy message-proxy codeword pair may comprise performing at least one of: using the randomly selected proxy message and a lookup table to obtain the proxy codeword of the proxy message-proxy codeword pair; encoding the randomly selected proxy message to obtain the proxy codeword of the proxy message-proxy codeword pair; using the randomly selected proxy codeword and a lookup table to obtain the proxy message of the proxy message-proxy codeword pair; or encoding the randomly selected proxy codeword to obtain the proxy message of the proxy message-proxy codeword pair.

According to an aspect, there is provided a non-transitory computer readable medium comprising program instructions that, when executed by an apparatus, cause the apparatus to perform at least the method according to any of the preceding aspects.

In the above, many different embodiments have been described. It should be appreciated that further embodiments may be provided by the combination of any two or more of the embodiments described above.

## DESCRIPTION OF FIGURES

Embodiments will now be described, by way of example only, with reference to the accompanying Figures in which:

Figure 1 shows a representation of a network system according to some example embodiments;
Figure 2 shows a representation of a control apparatus according to some example embodiments;
Figure 3 shows a representation of an apparatus according to some example embodiments;
Figure 4 shows an example configuration;
Figure 5 illustrates example signalling;
Figure 6 shows an example configuration;
Figure 7 illustrates example operations that may be performed by an apparatus described herein;
Figure 8 illustrates example operations that may be performed by an apparatus described herein;
Figure 9 illustrates example operations that may be performed by an apparatus described herein; and
Figure 10 illustrates example operations that may be performed by an apparatus described herein.

## DETAILED DESCRIPTION

The following describes operations that may be performed in relation to providing mechanisms and apparatus for providing a more secure environment for decoding a received message.

In more detail, the following discloses mechanisms for modifying a received noisy codeword using a proxy codeword to produce a modified codeword that is provided to a decoder. It is understood in the following that the term "proxy codeword" in the following may alternatively be labelled any of "replaceable codeword", "nonce codeword", "simulated codeword", "dummy codeword", or "generated codeword". Using the modified codeword means that the decoder cannot recover the original message at the end of its decoding processes. Instead, the decoder decodes the modified codeword to obtain a decoded message that comprises both the original message and a proxy message. It is understood in the following that the term "proxy message" in the following may alternatively be labelled any of "replaceable message", "nonce message", "simulated message", "dummy message", or "generated message".

The system comprising the decoder is configured such that the decoder has no knowledge of the proxy message, and so cannot determine the original message from the determined decoded message. The system is further configured such that at least one other entity comprised in the system has knowledge of the proxy message. Consequently, the at least one other entity may recover the original message from the decoded message using its knowledge of the proxy message.

This process may be implemented in any of a plurality of different ways, some of which are described below.

For example, a receiver may receive a noisy codeword over a channel, modify the noisy codeword by combining it with a proxy codeword to produce a modified codeword, and provide the modified codeword to the decoder for decoding. The proxy codeword is paired with a proxy message. The combination may be linear (although it is understood that the combination may be non-linear), and the noisy codeword may have been encoded using a linear code. The output of the decoder comprises a modified codeword that comprises the proxy message and an original message (e.g., a desired message for processing). The decoder may cause the modified message to be provided back to the receiver, or to another apparatus for processing. The modified message may be manipulated by the receiver or the another apparatus to remove the proxy message, thus returning the desired message. As part of this process, there is provided an entity that randomly generates a proxy message-proxy codeword pair for use in this process, and that causes at least one of the proxy message or proxy codeword of said pair to be provided to the receiver or the another apparatus.

Although these described mechanisms may be applied in respect of any decoder, they are especially useful in the context of untrusted decoders as the addition of the proxy codeword helps to guarantee secrecy of the original message. For example, a decoder may be provided by a chip manufactured by an untrusted manufacturer, and/or by a remote entity that is untrusted by the apparatus receiving the message.

Although more detailed information regarding how the received message may be modified to form the modified system is provided below, the following provides a brief overview of some of the components of potential communication environments, with reference to 3GPP communication systems. It is understood, however, that this is merely provided to illustrate an example communication environment, and that the presently described principles may be deployed in other communication environments (e.g., in Bluetooth environments, IEEE 802.11, etc.).

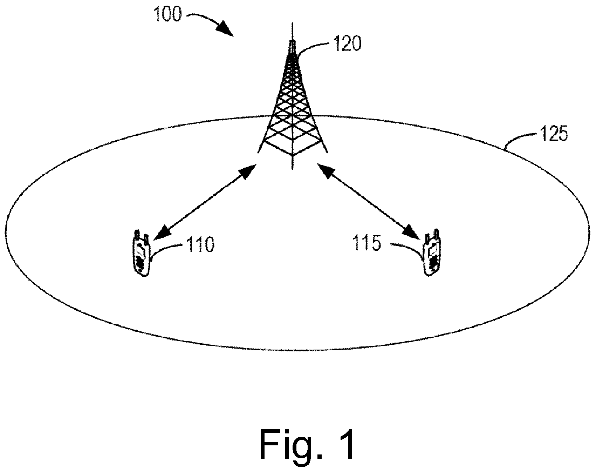

Figure 1 illustrates an example communication environment in which example embodiments of the present disclosure can be implemented.

Figure 1 shows an example communication environment 100 in which example embodiments of the present disclosure can be implemented.

In the communication environment 100, a plurality of communication devices, comprising user devices 110 and 115 (also referred to herein as a "terminal" or "terminal device") and a network device 120 (also referred to herein as a "network access node"), can communicate with each other. The network device 120 may serve a coverage area, called a cell 125. The user device 110 may have access to a communication network via the cell 125. In some example embodiments, both the user device 110 and the network device 120 may be configured to implement a beamforming technique and communicate with each other via a plurality of beams.

The term "terminal device" refers to any end device that may be capable of wireless communication. By way of example rather than limitation, a terminal device may also be referred to as a communication device, user equipment (UE), a Subscriber Station (SS), a Portable Subscriber Station, a mobile device, a Mobile Station (MS), or an Access Terminal (AT). The terminal device may include, but not limited to, a mobile phone, a cellular phone, a smart phone, voice over IP (VoIP) phones, wireless local loop phones, a tablet, a wearable terminal device, a personal digital assistant (PDA), portable computers, desktop computer, image capture terminal devices such as digital cameras, gaming terminal devices, music storage and playback appliances, vehicle-mounted wireless terminal devices, wireless endpoints, mobile stations, laptop-embedded equipment (LEE), laptop-mounted equipment (LME), USB dongles, smart devices, wireless customer-premises equipment (CPE), a machine-type communications (MTC) device, an Internet of Things (IoT) device, a watch or other wearable, a head-mounted display (HMD), a vehicle, a drone, a medical device and applications (e.g., remote surgery), an industrial device and applications (e.g., a robot and/or other wireless devices operating in an industrial and/or an automated processing chain contexts), a consumer electronics device, a device operating on commercial and/or industrial wireless networks, and the like. The terminal device may also correspond to a Mobile Termination (MT) part of an IAB node (e.g., a relay node). In the following description, the terms "terminal device", "communication device", "terminal", "user device", "user equipment" and "UE" may be used interchangeably.

As used herein, the term "network device" is used interchangeably with "network access node", and refers to a node in a communication network via which a terminal device accesses the network and receives services therefrom. The network device may refer to a base station (BS) or an access point (AP), for example, a node B (NodeB or NB), an evolved NodeB (eNodeB or eNB), an NR NB (also referred to as a gNB), a Remote Radio Unit (RRU), a radio header (RH), a remote radio head (RRH), a relay, an Integrated Access and Backhaul (IAB) node, a low power node such as a femto, a pico, a non-terrestrial network (NTN) or non-ground network device such as a satellite network device, a low earth orbit (LEO) satellite and a geosynchronous earth orbit (GEO) satellite, an aircraft network device, and so forth, depending on the applied terminology and technology. In some example embodiments, radio access network (RAN) split architecture comprises a Centralized Unit (CU) and a Distributed Unit (DU) at an IAB donor node. An IAB node comprises a Mobile Terminal (IAB-MT) part that behaves like a UE toward the parent node, and a DU part of an IAB node behaves like a base station toward the next-hop IAB node.

In some example embodiments, a link from the network device 120 to the user device 110 or 115 is referred to as a DL, while a link from the user device 110 or 115 to the network device 120 is referred to as a UL. Links are also referred to herein as "channels". In DL, the network device 120 is a Tx device (or a transmitter), and the user device 110 or 115 is a Rx device (or a receiver). In UL, the user device 110 or 115 is a Tx device (or a transmitter), and the network device 120 is a Rx device (or a receiver). A link between the user device 110 and another user device (not shown) is referred to as a sidelink (SL). In SL, one of the user devices is a Tx device (or a transmitter), and the other of the user devices is a Rx device (or a receiver).

Communications in the communication environment 100 may be implemented according to any proper communication protocol(s), comprising, but not limited to, cellular communication protocols of the first generation (1G), the second generation (2G), the third generation (3G), the fourth generation (4G), the fifth generation (5G), the sixth generation (6G), and the like, wireless local network communication protocols such as Institute for Electrical and Electronics Engineers (IEEE) 802.11 and the like, and/or any other protocols currently known or to be developed in the future. Moreover, the communication may utilize any proper wireless communication technology, comprising but not limited to: Code Division Multiple Access (CDMA), Frequency Division Multiple Access (FDMA), Time Division Multiple Access (TDMA), Frequency Division Duplex (FDD), Time Division Duplex (TDD), Multiple-Input Multiple-Output (MIMO), Orthogonal Frequency Division Multiple (OFDM), Discrete Fourier Transform spread OFDM (DFT-s-OFDM) and/or any other technologies currently known or to be developed in the future.

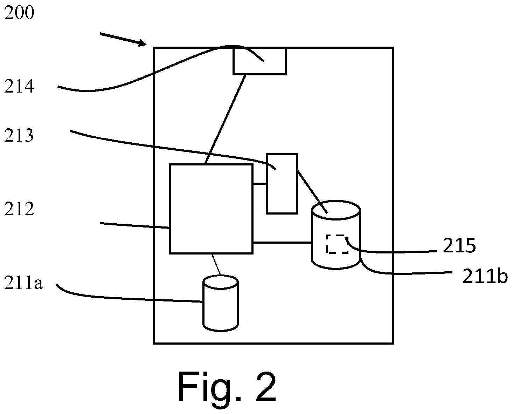

Figure 2 illustrates an example of a control apparatus 200 for causing a network device 120 (such as the network device described in Figure 1) to perform its operations. The control apparatus may comprise at least one random access memory (RAM) 211a, at least on read only memory (ROM) 211b, at least one processor 212, 213 and an input/output interface 214. The at least one processor 212, 213 may be coupled to the RAM 211a and the ROM 211b. The at least one processor 212, 213 may be configured to execute an appropriate software code 215. The software code 215 may for example allow to perform one or more steps to perform one or more of the present aspects. The software code 215 may be stored in the ROM 211b. The control apparatus 200 may be interconnected with another control apparatus 200 controlling another function of the network device. In some embodiments, each function of the network device comprises a control apparatus 200. In some exemplary embodiments, the apparatus 200 may be implemented at the network device 120 or may be the network device 120.

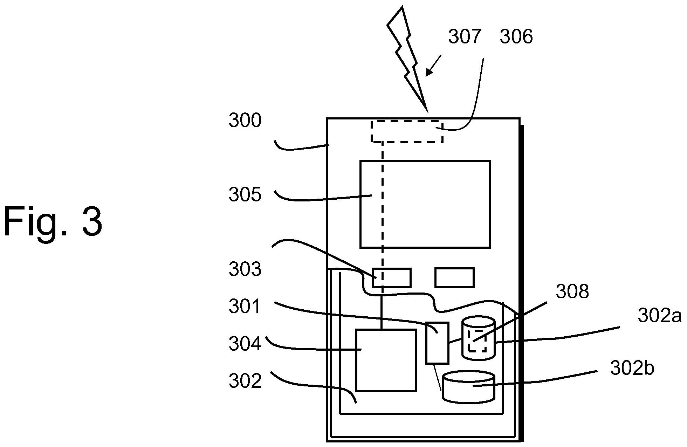

Figure 3 illustrates an example of a terminal 300, such as the user device 110, 115 illustrated on Figure 1. The terminal 300 may be provided by any device capable of sending and receiving radio signals, such as the user device described herein. The terminal 300 may provide, for example, communication of data for carrying communications. The communications may be one or more of voice, electronic mail (email), text message, multimedia, data, machine data and so on.

The terminal 300 may receive signals over an air or radio interface 307 via appropriate apparatus for receiving and may transmit signals via appropriate apparatus for transmitting radio signals. In Figure 3 transceiver apparatus is designated schematically by block 306. The transceiver apparatus 306 may be provided for example by means of a radio part and associated antenna arrangement. The antenna arrangement may be arranged internally or externally to the mobile device.

The terminal 300 may be provided with at least one processor 301, at least one memory ROM 302a, at least one RAM 302b and other possible components 303 for use in software and hardware aided execution of tasks it is designed to perform, including control of access to and communications with access systems (such as a network access system provided by the network device described above in relation to Figures 1 and 2) and other communication devices. The at least one processor 301 is coupled to the RAM 302b and the ROM 302a. The at least one processor 301 may be configured to execute an appropriate software code 308. The software code 308 may for example allow to perform one or more of the present aspects. The software code 308 may be stored in the ROM 302a.

The processor, storage and other relevant control apparatus can be provided on an appropriate circuit board and/or in chipsets. This feature is denoted by reference 304. The device may optionally have a user interface such as key pad 305, touch sensitive screen or pad, combinations thereof or the like. Optionally one or more of a display, a speaker and a microphone may be provided depending on the type of the device.

In some exemplary embodiments, the terminal 300 may be an apparatus comprising at least one processor and at least one memory storing instructions that, when executed by the at least one processor, cause a user device 110, 115 to perform examples or embodiments described in this document.

One of the steps involved in communicating data between a sender a receiver includes encoding data for transmission through a medium at a channel encoder at the transmitter, and decoding the received data at a channel decoder at the receiver. Encoding signals can be useful for a variety of purposes, including improving the security of the transmitted signals (e.g., from third party interceptors) and improving the integrity of the transmitted signals (e.g., making it more likely that a signal will be decoded correctly at the receiver).

In more detail, when information (e.g., data traffic and/or control signals) is transmitted from a transmitter to a receiver, it is often transmitted in an encoded form in order to make the transmission more secure.

Encoding is the process of translating information into a form that can be transmitted to another apparatus. The encoded form of the information is often referred to as a "codeword". Stated differently, the transmitter forms a codeword by modifying an original message using an encoding mechanism, and transmits the codeword to a transmitter over a channel. Often, the modification of the original message (e.g., the encoding of the original message) involves the insertion of additional bits (such as parity bits, as described further below) into the original message. Therefore, the transmitted codeword is larger than the original message.

The codeword received at the receiver may be different to the codeword transmitted by the transmitter as the channel may have corrupted the transmitted codeword during transmission (e.g., by inserting additional bits, flipping binary bits, etc.). The codeword received at the transmitter is therefore called a "noisy codeword", as it corresponds to the combination of the transmitted codeword and the noise of the channel.

For example, considering a noisy channel uncertainty, a message W is transmitted through a noisy channel by using encoding and decoding functions. An encoder maps W into a pre-defined sequence of channel symbols of length n (e.g., the encoder maps W into a codeword to be transmitted). In its most basic model, the channel distorts each of these symbols independently of the others. The output of the channel (e.g., the noisy codeword) is fed into a decoder, which maps the sequence into an estimate of the original message.

In particular, when the receiver wants to recover the original message, the receiver uses a decoder to remove the additional bits from the received noisy codeword to recover the transmitted codeword. The transmitted codeword is then converted into the original message by removing the additional bits.

Encoding can be performed in a plurality of different ways, some of which are described below. In general, the code used for encoding data for transmission is selected based on the communication protocol used (e.g., as different communication protocol standards may specify which codes are available for use within that communication protocol), capabilities of the transmitter and/or receiver, and conditions of the communication medium over which the signals are transmitted.

The following are examples of codes that have been used for encoding signals for transmissions: repetition codes, parity codes, cyclic codes, Hamming codes, Reed-Muller codes, low-density parity-check (LDPC) codes, multidimensional parity-check codes, and turbo codes. It is understood that this list is not exhaustive. A brief description of these codes is provided below.

- Repetition code is a linear error-correcting code that involves repeatedly transmitting a signal several times. Repetition code may be useful for assisting a receiver to determine that the signal is being transmitted over a noisy channel as a noisy channel may corrupt at least one of the redundant (e.g., repeated) signals.

- Parity code is an error detecting code that involves adding a parity bit (also known as a "check bit") into a signal being transmitted in order to ensure the number of bits is either even or odd (depending on the configuration of the transmitter). Parity code may be useful for assisting a receiver to determine that the signal is being transmitted over a noisy channel as a noisy channel may corrupt the parity of the transmitted signals (e.g., instead of all having all-even or all-odd parity, the signal may comprise a mix of even and odd parity).

- Cyclic code is a linear error correcting code in which a circular shift of each codeword provides another codeword, giving another word belonging to the code. An example cyclic shift may include, for example, for each iteration, causing the least significant bit to become the most significant bit, and shifting the remaining bits by one bit. The receiver may use its knowledge of how the code will shift to correct bits that have been incorrectly received.

- Hamming code is a linear error-correcting code that involves arranging error correcting bits within a signal such that different incorrect bits produce different error results (and so may be used to identify the location of errors). The main idea is to select error-correcting bits such that the index-XOR (e.g., the XOR of all the bit positions containing a 1) is 0. The receiver may use Hamming code for detecting one-bit and two-bit errors, or for correcting one-bit errors without detecting errors.

- Reed-Muller code is a linear error-correcting code that involves mapping messages to codewords using a linear encoding function. The receiver may use this code to detect (and correct) errors by comparing, for each of a plurality of sets of multiple evaluation points, the parity sums of the multiple evaluation points to identify whether the parity of those evaluation points agree.

- LDPC code is a linear error correcting code that is used to protect messages over noisy transmission channels. They are constructed using a sparse Tanner graph. A Tanner graph is a bipartite graph used to state constraints or equations that specify error correcting codes (e.g., a graph whose vertices may be divided into two independent sets, known as check nodes and variable nodes). A channel code can be fully described by an (M X N) parity-check matrix H (referred to as H-matrix), where N represents a number of variable nodes (VNs) (e.g., a length of the code block) and M represents a number of check nodes (CNs). The check nodes may populate rows of the H-matrix, and the variable nodes may populate columns of the H-matrix.

- Multi-dimensional parity check code is a linear error correcting code that involves arranging the message into a multidimensional grid, and calculating a parity digit for each row and column by summing each column and row separately. The receiver may use this code to identify and correct a bit based on the assumption that only a single error occurred.

- Turbo code is a linear forward error correction code that involves sending two redundant, but different, sub-blocks of parity bits with the payload. The decoder may use the output of multiple decoders (included weighted confidence values in the output) to reconcile differences in the outputs.

Among these linear codes, LDPC codes and Turbo codes are quite widely adopted in communication protocol standards and practice.

It is noticeable that a lot of these codes are considered to be linear codes.

A linear code, by definition, has the following property: Let $C \subseteq F_q^n$ be a linear code of dimension $k$. A matrix $G \in F_q^{n \times k}$ is said to be a generator matrix for C if its k columns span C. The generator matrix G provides a way to encode a message $x \in F_q^k$ as the codeword $Gx \in C \subseteq F_q^n$.

Therefore, a linear code has an encoding map

$$E : F_q^k \to F_q^n$$

which is a linear transformation $x \to Gx$.

Based on this, if $x_1, x_2 \in F_q^k$ then $c_1 + c_2 = G(x_1 + x_2)$. This property of linear codes allows for linear decoding of the encoded message.

For example, when $D : F_q^n \to F_q^k$ represents the decoding procedure, then linearity of the coding means that: $D(G(x_1 + x_2)) = x_1 + x_2$.

Although there are a wide variety of linear codes available, the decoding block is consistently one of the most computationally complicated functions in a wireless receiver. This is because the noise introduced by the channel when converting the transmitted codeword into the noisy codeword is difficult to accurately predict, and so the determination of which bits in the noisy codeword are attributable to the introduced noise is computationally intensive.

One (non-exhaustive) example of a mechanism used for channel decoding is belief propagation (BP) decoding. For practical hardware implementation, belief propagation decoding for polar codes has been widely studied, due to its high throughput.

Belief propagation decoding mechanisms treat each parity check that makes up the linear code (e.g., that makes up the LDPC) as an independent single parity check (SPC) code. Each SPC code is decoded separately using soft-in-soft-out (SISO) techniques, and other derivates thereof. The soft decision information from each SISO decoding is cross-checked and updated with other redundant SPC decodings of the same information bit. Each SPC code is then decoded again using the updated soft decision information. This process is iterated until a valid codeword is achieved or decoding is exhausted. This type of decoding is often referred to as sum-product decoding. The decoding of the SPC codes is often referred to as the "check node" processing, and the cross-checking of the variables is often referred to as the "variable-node" processing.

Decoding complexity aside, it is expected that due to hardware supply chain security, hardware provided by third party untrusted entities may be used for decoding a received codeword in future communication systems. This especially could be the case for more sophisticated chip that accelerates decoding.

This is illustrated in the following three use cases are considered in the following, although it is understood that the presently described mechanisms are not limited to these use cases:

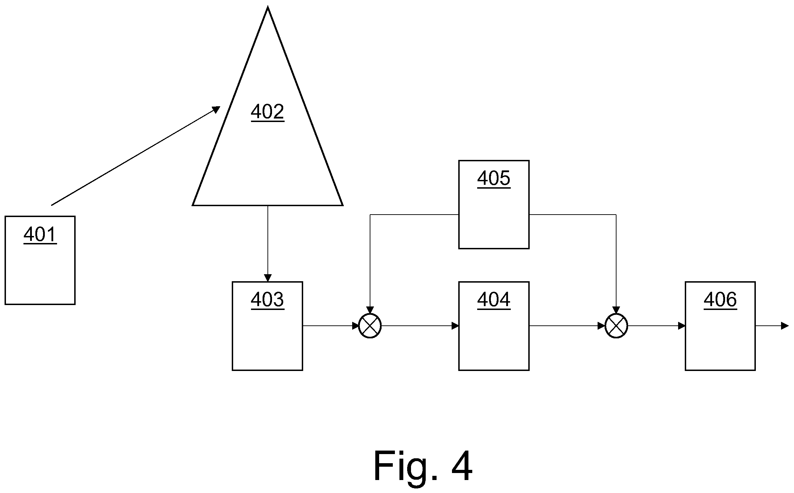

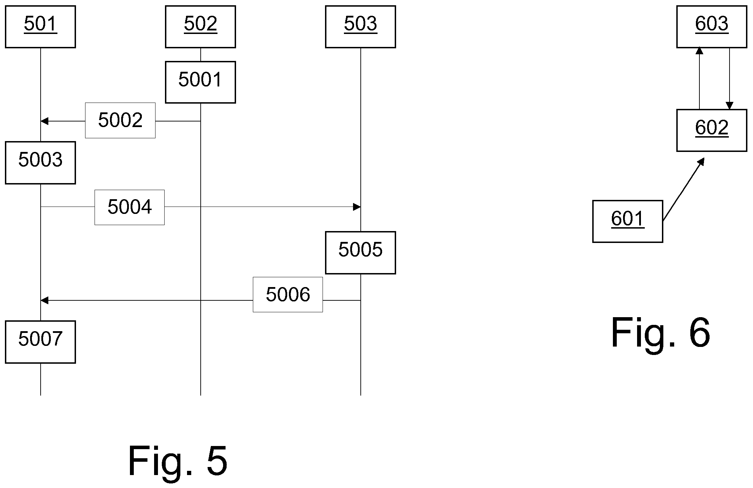

> **1)** In a first use case, an Open Radio Access Network (RAN) setup is considered in which the radio frequency (RF) and parts of a distributed unit (DU) baseband signal processing is provided by one vendor (trusted), while the decoding chip is provided by another vendor (extremely cheap, however, untrusted hardware, e.g. malware, trojans, etc.). In this scenario, the RF & baseband signal processing part could use the presently described techniques to recover an original message from a received noisy codeword. A mechanism for addressing this use case is illustrated with respect to Figures 4 and 5.
> **2)** In a second use case, an Internet of Things (IoT) device (or any other low-cost device) may be unable to implement complex channel decoding, and so determines to outsource this to an external decoder (e.g., located on a server, laptop, user equipment, etc.). A mechanism for addressing this use case is illustrated with respect to Figures 5 and 6.
> **3)** In a third use case, a home/private subnetwork (e.g., a user equipment such as a watch, phone, laptop) may be unable to implement complex channel decoding, and so determines to outsource this to an external decoder (e.g., located on a server, laptop, user equipment, etc.). A mechanism for addressing this use case is illustrated with respect to Figures 5 and 6.

In light of the expected outsourcing of decoding operations, the following considers mechanisms for improving the security of a decoding process, especially when the decoding is performed by an untrusted decoder.

In particular, the following proposes exploiting the above-mentioned linearity properties by generating a proxy codeword based on a corresponding proxy message.

The proxy codeword is combined with the received noisy codeword to form a modified codeword (e.g., by applying one-time padding techniques). Stated differently, the received noisy codeword is encoded (e.g., linearly encoded, such as being linearly combined) using the proxy codeword to form the modified codeword. To this effect, the proxy codeword may be considered as (or otherwise re-termed as) a replaceable mask. The proxy codeword (e.g., the replaceable mask) may be randomly generated.

The modified codeword is subsequently provided to the decoder, which performs a decoding process on the modified codeword for form a decoded message. The decoder is unaware that the decoded message is comprised of a combination of an original message and the proxy message. The decoder passes the decoded message to an apparatus trusted by the receiver of the noisy codeword, which removes the proxy message from decoded message to obtain the original message. The original message may subsequently be processed (e.g., passed to at least one of: a medium access control protocol level processing entity, a network protocol level processing entity, a transport protocol level processing entity, or a session protocol layer processing entity).

The proxy codeword may be termed a "padding codeword". The proxy message may be termed a "padding message".

Although the above-mentioned process may be useful for untrusted decoders, it is understood that the presently described techniques may also be performed in respect of trusted decoders. Further, the presently described techniques may be performed in respect of any type of decoder (e.g., belief propagation, successive cancellation decoding, maximum likelihood, etc.). The apparatus may use any mechanism and/or criteria for selecting a decoder to which to send the modified codeword. For example, the apparatus may obtain information on a current state of the available decoders (e.g., processing resources available), and use that information to select a decoder for decoding the modified codeword.

The following illustrates how the presently described techniques may be applied in a variety of different use cases.

A first use case relates to a radio access network node (e.g., a distributed unit) that is configured to cause channel decoding to be performed using an untrusted decoder. This is illustrated with respect to Figure 4.

Figure 4 illustrates a terminal 401 configured to transmit an original codeword (corresponding to an original message) to a receiver 402 of a distributed unit over a channel.

A baseband unit 403 of the distributed unit is configured to perform baseband processing of the received version of the original codeword to determine a noisy codeword. The noisy codeword is subsequently passed to the untrusted decoder 404 via a signal modifier 405. The signal modifier 405 is configured to cause a proxy codeword to be added to the noisy codeword to form a modified codeword, with the modified codeword being passed to the untrusted decoder 404. The proxy codeword corresponds to a proxy message. For example, the proxy codeword is formed using a one-time padding of the proxy message.

The untrusted decoder 404 is configured to decode the modified codeword, and output a decoded message. The decoded message is manipulated by an entity that is aware of the proxy message (e.g., the signal modifier or an apparatus trusted by the signal modifier) to remove the proxy message to form the original message. The decoded codeword is subsequently provided to another entity 406 for further processing (as described above). The another entity may comprise, for example, another trusted part of the distributed unit, and/or a trusted centralized unit.

These operations may also be represented as follows.

During a first step, the signal modifier 405 (e.g., a one-time pad unit) is triggered by a radio unit to generate a random number.

During a second step, a codeword mask, $c_m$, is subsequently selected at random by the signal modifier using the random number. The codeword mask is selected to comprise a distribution uniform over all the codeword set, generated by $G$ in $C \subseteq F_q^n$ to generate a proxy codeword. The proxy codeword ($c_m$) and a corresponding proxy message ($x_m$) are paired and saved in the memory as ($x_m$, $c_m$).

For example, the second step may be performed by randomly selecting the proxy message ($x_m$) and forming the proxy codeword ($c_m$) by encoding the proxy message using an encoding scheme. As another example, the second step may be performed by randomly selecting the proxy message ($x_m$) and forming the proxy codeword ($c_m$) by using a lookup table and the proxy message as an index to identify the proxy codeword. It is understood that these operations may be performed with the proxy message and the proxy codeword being interchanged.

It is understood that other mechanisms may be used for selecting at least one of the proxy codeword or the proxy message and using the selected information to obtain its corresponding pair (e.g., using a randomly selected proxy codeword to identify its corresponding proxy message, or using a randomly selected proxy message to identify its corresponding proxy codeword).

During a third step, the codeword $c_m$ is added to the noisy codeword $c_r$ output by the baseband unit 403.

During a fourth step, the combination of the noisy received $c_r$ and the codeword $c_m$ is sent to the decoder 404. The decoder may comprise, for example, any type of decoder, including universal decoders.

During a fifth step, the decoder outputs a decoded signal corresponding to the sum of the original information to be recovered and the generated message, $x_r + x_m$. During a sixth step, the decoded signal output $x_r + x_m$ and known $x_m$ are used to determine the original message encoded by the transmitter of $x_r$.

A second use case is illustrated with respect to Figure 6.

In the example of Figure 6, a receiving unit outsources its channel decoding computation to a decoder that is external to the receiver unit. This differs from the example of Figure 4 in which the decoder may be comprised internal to the apparatus. The decoder may comprise, for example, a server located locally to the receiving unit, such as a nearby terminal, or a server located remotely from the receiving unit (such as an entity comprised in a network).

Figure 6 illustrates a terminal 601 configured to transmit a codeword corresponding to an original message to a receiving unit 602, which receives the transmitted signaling as a noisy codeword. The receiving unit 602 determines that untrusted server 603 should perform decoding of noisy codeword. This determining may be performed based on a determination that the receiver does not have sufficient resources to decode the received signal and/or does not have sufficient resources to decode the received signal within a predetermined time duration.

Based on this determining, the receiving unit provides a modified codeword to the decoder. The modified codeword may be formed by a combination of the noisy codeword and a proxy codeword, as described above. The decoder decodes the modified codeword to output a decoded signal. The decoded signal is provided back to the receiving unit 602. The receiving unit uses the decoded signal and knowledge of how the modified codeword was form (e.g., of the proxy message that corresponds to the proxy codeword) to obtain an original message from the terminal (e.g., to obtain the original message corresponding to the transmitted codeword).

The steps involved in such an operation may thus be as follows.

During a first step, the receiving unit determines that a received noisy codeword is to be decoded by the server 603. This may be based, for example, based on a determination that a metric indicates that the channel used for transmission of the received noisy codeword is considered noisy.

For example, this determining to outsource decoding to server 603 may be based on a determination that the received noisy codeword has a low signal to noise ratio associated therewith. A low signal to noise ratio may be identified by comparing a measured value of a current signal to noise ratio to a preconfigured threshold value for the signal to noise ratio, and determining that the measured signal to noise ratio is low when the measured value is equal to or less than the preconfigured threshold value. It is understood that the determination does not have to be based on a signal to noise ratio, and that analogous determinations to outsource decoding to server 603 may be made for any other metric that varies based on channel noise.

During a second step, a codeword mask, $c_m$, is subsequently selected at random by the receiving unit using a random number. The codeword mask is selected to comprise a distribution uniform over all the codeword set, generated by $G$ in $C \subseteq F_q^n$ to generate a proxy codeword. The proxy codeword ($c_m$) and a corresponding proxy message ($x_m$) are paired and saved in the memory as ($x_m, c_m$). The selection of the proxy codeword and proxy message paid may be as described above.

During a third step, the proxy codeword $c_m$ is added to the noisy codeword $c_r$ to form the modified codeword $c_r + c_m$.

During a fourth step, the modified codeword $c_r + c_m$ is sent to the server. The server performs a decoding process on the modified codeword to output a decoded message of $x_r + x_m$.

During a fifth step, the server sends the decoded output of $x_r + x_m$ of the decoder back to the receiving unit. The signalling of the fourth and fifth step may be performed using any appropriate signalling protocol, and need not be further encoded for secrecy.

During a sixth step, the receiving unit, having received the decoded message $x_r + x_m$ and knowing the proxy message $x_m$, modifies the decoded message to replace the proxy message so as to output the received message of $x_r$. The received message of $x_r$ may be processed in the same way as any other decoded signal, in accordance with the configuration of the receiving unit.

This signalling of Figure 4 and/or 6 is illustrated with respect to Figure 5.

Figure 5 illustrates signalling that may be performed between a trusted entity 501 (e.g., baseband unit 403 or apparatus 602), a signal modifier 502 (e.g., signal modifier 405 or apparatus 602) and a decoder 503 (e.g., decoder 403 or 603).

During 5001, the signal modifier 502 generates a random (e.g., proxy) message ($x_m$), and a random (e.g., proxy) codeword ($c_m$) from a valid set of codewords. The generated random message and random codeword are stored as a pair as ($x_m, c_m$). The pair ($x_m, c_m$) is signalled to the trusted entity 501 during 5002. This signalling may be performed internally to an apparatus (e.g., via a bus) when the signal modifier and trusted entity are comprised in the same apparatus.

During 5003, the trusted entity creates a modified codeword ($c_r + c_m$) by summing the random codeword $c_m$ to a noisy codeword $c_r$ that corresponds to a codeword of a signal ($x_r$) received via a noisy channel.

The modified codeword $c_r + c_m$ is subsequently signalled from the trusted entity 501 to the decoder 503 during 5004.

During 5005, the decoder 503 uses the received modified codeword to determine a "modified" message, corresponding to the sum of the received signal ($x_r$) and the generated message ($x_m$). Stated differently, the decoder uses the received modified codeword ($c_r + c_m$) to determine a decoded message of $x_r + x_m$ during 5005.

During 5006, the decoder 503 signals the trusted entity 501 (or some other trusted party that can perform analogous functions to 5006 to 5007). This signalling may comprise the decoded message of $x_r + x_m$.

The trusted entity 501 subtracts the generated message ($x_m$) from the decoded message of $x_r + x_m$ to obtain the received message ($x_r$). The trusted entity 501 subsequently processes the received message ($x_r$) and performs actions based on the received message.

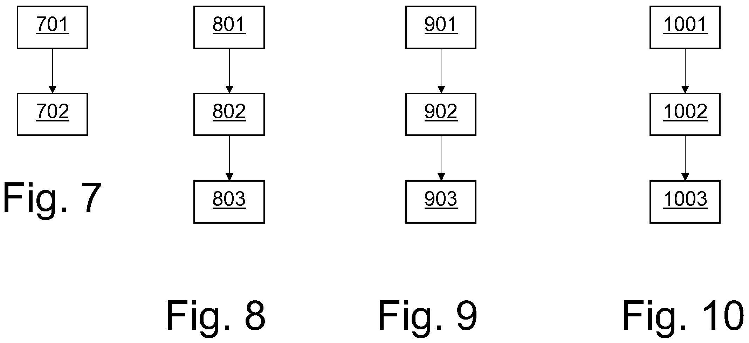

The following illustrates features of the apparatus of the above-described examples with reference to Figures 7 to 9. It is therefore understood that at least one feature mentioned below may find functional correspondence with functions performed by apparatus mentioned above, such that the above examples aid in understanding at least some of the ways in which the following described features may be performed.

Figure 7 illustrates operations that may be performed by a first apparatus. The first apparatus may comprise an apparatus that acts to cause the modified codeword to be formed. For example, in the above examples, the apparatus may comprise bas signal modifier 405 (and/or the combination of the baseband unit 403 and the signal modifier 405), signal modifier 502, and/or receiving unit 602. The first apparatus may comprise a standalone chipset. The first apparatus may be comprised as part of another apparatus (e.g., a receiver, a user device, a network apparatus, etc.).

During 701, the first apparatus causes a modified codeword to be formed by combining a noisy codeword received over a channel with a proxy codeword. Stated differently, the received noisy codeword is encoded (e.g., linearly encoded, such as being linearly combined) using the proxy codeword to form the modified codeword. To this effect, the proxy codeword may be considered as (or otherwise re-termed as) a replaceable mask. The proxy codeword (e.g., the replaceable mask) may be randomly generated.

The noisy codeword may have been formed by the combination of channel noise (originating from transmission over the channel from a transmitter to the first apparatus) with the original codeword encoded for transmission over the channel (e.g., channel encoded). The original codeword may have been encoded for transmission over the channel using a linear code.

During 702, the first apparatus causes the modified codeword to be provided to a decoder for decoding.

The decoder may be local to the first apparatus (e.g., provision of the modified codeword to the decoder is via a bus, or similar). The decoder may be remote from the first apparatus (e.g., the decoder may be located in another apparatus to the first apparatus). When the decoder is located remotely from the first apparatus, the modified codeword may be provided to the decoder by signalling it over another communication channel and/or communication link.

The first apparatus may generate the proxy codeword by randomly selecting the proxy codeword based on a valid set of codewords. Stated differently, the proxy codeword may be paired with, or otherwise correspond to, a selected code.

For example, the first apparatus may generate the proxy codeword by selecting a code, and generating the codeword based on the code. The selected code may be a one-time padding code. The code may be a proxy message.

The first apparatus may provide the selected code (e.g., proxy message) and/or the proxy codeword to at least one other apparatus. For example, in the example of Figure 4, the first apparatus may provide at least the proxy codeword and the proxy message (e.g., selected code) to an apparatus of the centralised unit. As another example, the first apparatus may provide the proxy codeword to another part of the receiving unit (e.g., receiving unit 602) when the first apparatus is comprised in the receiving unit.

The first apparatus may determine that the decoder is untrusted by the apparatus, and perform the causing the modified codeword to be provided to the decoder based on the determination that the decoder is untrusted by the apparatus. It is understood, however, that the modified codeword may alternatively be provided to a trusted decoder. Whether or not a decoder is considered trusted may be determined by at least one criterion configured at the first apparatus. For example, a decoder may be considered as untrusted when it is located remotely from the first apparatus. As another example, a decoder may be considered as untrusted when it was manufactured by a different manufacturer (and/or by a different operator) to that of the first apparatus.

The apparatus may receive, from the decoder, a decoded message that comprises an original message and a proxy message, remove the proxy message from the decoded message to recover the original message, and cause the original message to be provided to a second apparatus for processing. For example, in the above examples, the first apparatus may comprise a distributed unit, while the second apparatus comprises a centralised unit. The centralised unit may process the original message. The original message may comprise, for example, a form of information that was encoded for channel transmission by the transmitter.

Figure 8 illustrates operations that may be performed by a second apparatus. The second apparatus may be standalone (e.g., remote) from the first apparatus of Figure 7. For example, the second apparatus may be the centralised unit in the example of Figure 4. The second apparatus may be local to the first apparatus of Figure 7. For example, the first and second apparatus may both be comprised as part of the receiving unit 602 in the example of Figure 6.

During 801, the apparatus receives, from a decoder, a decoded message that comprises an original message and a proxy message. The original message may comprise, for example, a form of information that was encoded for channel transmission by the transmitter.

During 802, the apparatus removes the proxy message from the decoded message to recover the original message.

During 803, the apparatus processes the original message.

The apparatus may receive the proxy message from a first apparatus. The first apparatus may comprise, for example, the first apparatus of Figure 7.

The second apparatus may receive the proxy message from the first apparatus with a corresponding proxy codeword. Stated differently, the second apparatus may receive a proxy message-proxy codeword pair. The proxy codeword may have a one-to-one mapping with the proxy message at the first apparatus.

When the second apparatus is local to the first apparatus, the second apparatus may perform at least one of the functions performed by the first apparatus. For example, the second apparatus may generate the proxy message-proxy codeword pair. Stated differently, the second apparatus may generate a proxy codeword corresponding to the proxy message by randomly selecting the proxy codeword from a valid set of codewords. The generating the proxy codeword may comprise selecting a code (e.g., a one-time padding code and/or proxy message), and generating the proxy codeword based on the code. The second apparatus may provide the proxy message and the proxy codeword to another apparatus.

Figure 9 illustrates operations that may be performed by a decoder apparatus. The decoder apparatus may comprise the decoder mentioned above in relation to any of Figures 7 and/or 8.

During 901, the decoder apparatus receives, from first apparatus, a modified codeword that comprises a noisy codeword and a proxy codeword. The first apparatus may comprise the first apparatus of Figure 7.

During 902, the decoder apparatus determines, based on the modified codeword, a decoded message that comprises an original message and a proxy message.

During 903, the apparatus provides the decoded message to second apparatus. The second apparatus may comprise the second apparatus of Figure 8.

The second apparatus may be located locally to the first apparatus. For example, the second apparatus may comprise the first apparatus. This may correspond to an example configuration similar to Figure 6. The second apparatus may be located remotely from the second apparatus. This may correspond to an example configuration similar to Figure 4.

The decoder apparatus of Figure 9 may be located remotely from the first apparatus and/or the second apparatus. For example, the decoder may comprise an application server (e.g., an edge application server) that provides a decoding service to clients.

Figure 10 illustrates operations that may be performed by a third apparatus. The third apparatus may correspond to a standalone generator of the proxy message-proxy codeword pair. For example, the third apparatus may be the signal modifier 405 described above.

During 1001, the third apparatus randomly selects at least one of a proxy message or a proxy codeword. The random selection may be initiated (e.g., triggered) in response to at least one request for this generation from an entity (e.g., the first apparatus described above in relation to Figure 7) that has received a noisy codeword over a channel.

During 1002, the third apparatus determines a proxy message-proxy codeword pair using the selected at least one of the proxy message or proxy codeword.

During 1003, the third apparatus provides at least one of the proxy message or proxy codeword of said pair to another apparatus. The another apparatus may comprise the first apparatus of Figure 7. The another apparatus may comprise the second apparatus of Figure 8.

The random selection may comprise generating a number, and using the randomly generated number to perform said selecting. For example, the generated number may be used as an index for identifying at least one of the proxy message or proxy codeword. As another example, the generated number may be used as the proxy message or proxy codeword.

The determining the proxy message-proxy codeword pair may comprise performing at least one of: using the randomly selected proxy message and a lookup table to obtain the proxy codeword of the proxy message-proxy codeword pair; encoding the randomly selected proxy message to obtain the proxy codeword of the proxy message-proxy codeword pair; using the randomly selected proxy codeword and a lookup table to obtain the proxy message of the proxy message-proxy codeword pair; or encoding the randomly selected proxy codeword to obtain the proxy message of the proxy message-proxy codeword pair.

Technical Clauses:

A method for a first apparatus, the method comprising:

causing a modified codeword to be formed by combining a noisy codeword received over a channel with a proxy codeword; and
causing the modified codeword to be provided to a decoder for decoding.

A method for a second apparatus, the method comprising:

receiving, from a decoder, a decoded message that comprises an original message and a proxy message;
removing the proxy message from the decoded message to recover the original message; and
processing the original message.

A method for a decoder apparatus, the method comprising:

receiving, from another apparatus, a modified codeword that comprises a noisy codeword and a proxy codeword;
determining, based on the modified codeword, a decoded message that comprises an original message and a proxy message; and
providing the decoded message to another entity.

A method for a third apparatus, the method comprising:

randomly selecting at least one of a proxy message or a proxy codeword;
determining a proxy message-proxy codeword pair using the selected at least one of the proxy message or proxy codeword; and
providing at least one of the proxy message or proxy codeword of said pair to another apparatus.

A computer program comprising instructions which, when the program is executed by a computer of a first apparatus, cause the computer to carry out:

causing a modified codeword to be formed by combining a noisy codeword received over a channel with a proxy codeword; and
causing the modified codeword to be provided to a decoder for decoding.

A computer program comprising instructions which, when the program is executed by a computer of a second apparatus, cause the computer to carry out:

receiving, from a decoder, a decoded message that comprises an original message and a proxy message;
removing the proxy message from the decoded message to recover the original message; and

processing the original message.

A computer program comprising instructions which, when the program is executed by a computer of a decoder apparatus, cause the computer to carry out:

receiving, from another apparatus, a modified codeword that comprises a noisy codeword and a proxy codeword;
determining, based on the modified codeword, a decoded message that
comprises an original message and a proxy message; and providing the decoded message to another entity.

A computer program comprising instructions which, when the program is executed by a computer of a third apparatus, cause the computer to carry out:

randomly selecting at least one of a proxy message or a proxy codeword;
determining a proxy message-proxy codeword pair using the selected at least one of the proxy message or proxy codeword; and
providing at least one of the proxy message or proxy codeword of said pair to another apparatus.

It is understood in the above that where the decoder is located remotely to the receiver (e.g., for examples in which the modified codeword is provided to the decoder via a transmission medium (e.g., Bluetooth, Wi-Fi, etc.), some encryption may be omitted as the modified codeword already corresponds to an encoded signal. This may thus save additional processing resources and reduce a complexity of the system.

It should be understood that the apparatuses may comprise or be coupled to other units or modules etc., such as radio parts or radio heads, used in or for transmission and/or reception. Although the apparatuses have been described as one entity, different modules and memory may be implemented in one or more physical or logical entities.

It is noted that whilst some embodiments have been described in relation to 5G networks, similar principles can be applied in relation to other networks and communication systems. Therefore, although certain embodiments were described above by way of example with reference to certain example architectures for wireless networks, technologies and standards, embodiments may be applied to any other suitable forms of communication systems than those illustrated and described herein.

It is also noted herein that while the above describes example embodiments, there are several variations and modifications which may be made to the disclosed solution without departing from the scope of the present invention.

As used herein, "at least one of the following: <a list of two or more elements>" and "at least one of <a list of two or more elements>" and similar wording, where the list of two or more elements are joined by "and" or "or", mean at least any one of the elements, or at least any two or more of the elements, or at least all the elements.

In general, the various embodiments may be implemented in hardware or special purpose circuitry, software, logic or any combination thereof. Some aspects of the disclosure may be implemented in hardware, while other aspects may be implemented in firmware or software which may be executed by a controller, microprocessor or other computing device, although the disclosure is not limited thereto. While various aspects of the disclosure may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

As used in this application, the term "circuitry" may refer to one or more or all of the following:

(a) hardware-only circuit implementations (such as implementations in only analog and/or digital circuitry) and
(b) combinations of hardware circuits and software, such as (as applicable):
(c) a combination of analog and/or digital hardware circuit(s) with software/firmware and
(d) any portions of hardware processor(s) with software (including digital signal processor(s)), software, and memory(ies) that work together to cause an apparatus, such as a mobile phone or server, to perform various functions) and
(e) hardware circuit(s) and or processor(s), such as a microprocessor(s) or a portion of a microprocessor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

The embodiments of this disclosure may be implemented by computer software executable by a data processor of the mobile device, such as in the processor entity, or by hardware, or by a combination of software and hardware. Computer software or program, also called program product, including software routines, applets and/or macros, may be stored in any apparatus-readable data storage medium and they comprise program instructions to perform particular tasks. A computer program product may comprise one or more computer-executable components which, when the program is run, are configured to carry out embodiments. The one or more computer-executable components may be at least one software code or portions of it.

Further in this regard it should be noted that any blocks of the logic flow as in the Figures may represent program steps, or interconnected logic circuits, blocks and functions, or a combination of program steps and logic circuits, blocks and functions. The software may be stored on such physical media as memory chips, or memory blocks implemented within the processor, magnetic media such as hard disk or floppy disks, and optical media such as for example DVD and the data variants thereof, CD. The physical media is a non-transitory media.

The term "non-transitory," as used herein, is a limitation of the medium itself (i.e., tangible, not a signal) as opposed to a limitation on data storage persistency (e.g., RAM vs. ROM).

The memory may be of any type suitable to the local technical environment and may be implemented using any suitable data storage technology, such as semiconductor-based memory devices, magnetic memory devices and systems, optical memory devices and systems, fixed memory and removable memory. The data processors may be of any type suitable to the local technical environment, and may comprise one or more of general-purpose computers, special purpose computers, microprocessors, digital signal processors (DSPs), application specific integrated circuits (ASIC), FPGA, gate level circuits and processors based on multi core processor architecture, as non-limiting examples.

Embodiments of the disclosure may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

The scope of protection sought for various embodiments of the disclosure is set out by the independent claims. The embodiments and features, if any, described in this specification that do not fall under the scope of the independent claims are to be interpreted as examples useful for understanding various embodiments of the disclosure.

The foregoing description has provided by way of non-limiting examples a full and informative description of the exemplary embodiment of this disclosure. However, various modifications and adaptations may become apparent to those skilled in the relevant arts in view of the foregoing description, when read in conjunction with the accompanying drawings and the appended claims. However, all such and similar modifications of the teachings of this disclosure will still fall within the scope of this invention as defined in the appended claims. Indeed, there is a further embodiment comprising a combination of one or more embodiments with any of the other embodiments previously discussed.

## Claims

1. A first apparatus comprising means for performing:

   causing (701) a modified codeword to be formed by combining a noisy codeword received over a channel with a proxy codeword; and
   causing (702) the modified codeword to be provided to a decoder for decoding.

2. A first apparatus as claimed in claim 1, further comprising means for generating the proxy codeword by randomly selecting the proxy codeword based on a valid set of codewords.

3. A first apparatus as claimed in claim 2, wherein the means for generating the proxy codeword comprises means for selecting a code, and generating the codeword based on the code.

4. A first apparatus as claimed in any of claims 2 to 3, wherein the proxy codeword corresponds to a proxy message, and wherein the apparatus comprises means for providing the proxy message and the proxy codeword to another apparatus.

5. A first apparatus as claimed in any preceding claim, further comprising means for determining that the decoder is untrusted by the apparatus, wherein the means for causing the modified codeword to be provided to the decoder comprises means for causing the modified codeword to be provided to the decoder based on the determination that the decoder is untrusted by the apparatus.

6. A first apparatus as claimed in any preceding claim, further comprising means for performing:

   receiving, from the decoder, a decoded message that comprises an original message and a proxy message;
   removing the proxy message from the decoded message to recover the original message; and
   causing the original message to be provided to a second apparatus for processing.

7. A second apparatus comprising means for performing:

receiving (801), from a decoder, a decoded message that comprises an original message and a proxy message;

removing (802) the proxy message from the decoded message to recover the original message; and

processing (803) the original message.

8. A second apparatus as claimed in claim 7, further comprising means for receiving the proxy message from a first apparatus.

9. A second apparatus as claimed in claim 8, further comprising means for receiving the proxy message from the first apparatus with a corresponding proxy codeword.

10. A second apparatus as claimed in any of claims 7 to 9, further comprising means for generating a proxy codeword corresponding to the proxy message by randomly selecting the proxy codeword from a valid set of codewords.

11. A second apparatus as claimed in claim 10, wherein the means for generating the proxy codeword comprises means for selecting a code, and generating the proxy codeword based on the code.

12. A decoder apparatus comprising means for performing:

receiving (901), from another apparatus, a modified codeword that comprises a noisy codeword and a proxy codeword;

determining (902), based on the modified codeword, a decoded message that comprises an original message and a proxy message; and

providing (903) the decoded message to another entity.

13. A third apparatus comprising means for performing:

randomly selecting (1001) at least one of a proxy message or a proxy codeword;

determining (1002) a proxy message-proxy codeword pair using the selected at least one of the proxy message or proxy codeword; and

providing (1003) at least one of the proxy message or proxy codeword of said pair to another apparatus.

14. A third apparatus as claimed in claim 13, wherein the means for randomly selecting comprises means for:

randomly generating a number; and

using the randomly generated number to perform said selecting.

15. A third apparatus as claimed in any of claims 13 to 14, wherein the means for determining the proxy message-proxy codeword pair comprises means for performing at least one of:

using the randomly selected proxy message and a lookup table to obtain the proxy codeword of the proxy message-proxy codeword pair;

encoding the randomly selected proxy message to obtain the proxy codeword of the proxy message-proxy codeword pair;

using the randomly selected proxy codeword and a lookup table to obtain the proxy message of the proxy message-proxy codeword pair; or

encoding the randomly selected proxy codeword to obtain the proxy message of the proxy message-proxy codeword pair.

Fig. 1

Fig. 2

Fig. 3

Fig. 4

Fig. 6

Fig. 5

EP 4 618 456 A2

| 701 |
|-----|

↓

| 702 |
|-----|

# Fig. 7

| 801 |
|-----|

↓

| 802 |
|-----|

↓

| 803 |
|-----|

# Fig. 8

| 901 |
|-----|

↓

| 902 |
|-----|

↓

| 903 |
|-----|

# Fig. 9

| 1001 |
|------|

↓

| 1002 |
|------|

↓

| 1003 |
|------|

# Fig. 10